# EUROPEAN PATENT APPLICATION

(11) **EP 4 851 997 A1**
(43) Date of publication of application: **09.12.2026**
(21) Application number: 26180920.6
(22) Date of filing: 26.05.2026
(51) Int. Cl.: G11C 7/10, G11C 5/02, G11C 11/4093

(54) **MEMORY DEVICE SINGLE-ENDED LEVEL SHIFTER WITH DUTY CYCLE CORRECTION**

(30) Priority: 05.06.2025 US 202563818660 P; 06.11.2025 US 202519382223
(71) Applicant: Samsung Electronics Co., Ltd., Suwon-si, Gyeonggi-do 16677 (KR)
(72) Inventor: PARK, Joung Won, San Jose, CA 95134 (US); KIM, Jaehyup, San Jose, CA 95134 (US); YANG, Daeho, San Jose, CA 95134 (US); LEE, Dong Uk, San Jose, CA 95134 (US)
(74) Representative: Kuhnen & Wacker Patent- und Rechtsanwaltsbüro PartG mbB

(57) **Abstract**

Provided are systems, methods, and apparatuses for memory device single-ended level shifters with duty cycle correction. In one or more examples, the systems, devices, and methods include connecting, based on a through silicon via, a receiver of a base layer to a transmitter of a chip layer positioned over the base layer; receiving, at a first inverter of the receiver, a data signal from the chip layer, the first inverter comprising a first NMOS transistor, a first PMOS transistor, and a first stack of PMOS transistors connected to a source terminal of the first PMOS transistor; and receiving, at a second inverter of the receiver, a processed data signal from the first inverter, the second inverter comprising a second NMOS transistor and a second PMOS transistor.

## Description

### TECHNICAL FIELD

The disclosure relates generally to memory systems. In particular, the subject matter relates to memory device single-ended level shifters with duty cycle correction.

### BACKGROUND

The present background section is intended to provide context only, and the disclosure of any concept in this section does not constitute an admission that said concept is prior art.

Stacked memory devices can include a type of computer memory that implements stacked layers of memory stacked memory to achieve high data transfer rates and lower power consumption. Stacked memory can use stacking technology (e.g., 2.5D and/or 3D stacking technology) to pack more memory chips into a smaller space, which reduces the distance data needs to travel between the processor and memory. Stacked memory can include high bandwidth memory (HBM), 3D-stacked dynamic random-access memory (DRAM), vertically stacked DRAM (VS-DRAM), etc.

### SUMMARY

In various embodiments, the systems and methods described herein include systems, methods, and apparatuses for memory device single-ended level shifters with duty cycle correction. In some aspects, the techniques described herein relate to a device including: a chip layer of multiple chip layers positioned over a base layer; a through silicon via that connects a receiver of the base layer to a transmitter of the chip layer; a first inverter of the receiver including a first NMOS transistor, a first PMOS transistor, and a first stack of PMOS transistors connected to a source terminal of the first PMOS transistor; and a second inverter of the receiver including a second NMOS transistor and a second PMOS transistor, an input of the second inverter connected to an output of the first inverter.

In some aspects, the techniques described herein relate to a device, wherein: an input of the first inverter includes a common gate of the first NMOS transistor and the first PMOS transistor, the input of the first inverter connecting to a first voltage source; and a terminating source terminal of the stack of PMOS transistors connects to a second voltage source that differs from the first voltage source.

In some aspects, the techniques described herein relate to a device, wherein a source of the second PMOS transistor connects to the second voltage source. In some aspects, the techniques described herein relate to a device, wherein: the input of the second inverter includes a common gate of the second NMOS transistor and the second PMOS transistor; and the output of the first inverter includes a common drain of the first NMOS transistor and the first PMOS transistor.

In some aspects, the techniques described herein relate to a device, wherein the second inverter includes a second stack of PMOS transistors connected to a source terminal of the second PMOS transistor. In some aspects, the techniques described herein relate to a device, wherein a first pull-down strength of the first NMOS transistor differs from a second pull-down strength of the second NMOS transistor.

In some aspects, the techniques described herein relate to a device, wherein: a third inverter of the receiver connected to the second inverter, the third inverter including a third NMOS transistor and a third PMOS transistor; and a fourth inverter of the receiver connected to the third inverter, the fourth inverter including a fourth NMOS transistor and a fourth PMOS transistor.

In some aspects, the techniques described herein relate to a device, wherein: a source of the fourth PMOS transistor is connected to a fifth PMOS transistor configured as a first variable resistor; and a source of the fourth NMOS transistor is connected to a fifth NMOS transistor configured as a second variable resistor. In some aspects, the techniques described herein relate to a device, further including a group of NMOS transistors connected in series between a drain terminal of the second PMOS transistor and a drain terminal of the second NMOS transistor.

In some aspects, the techniques described herein relate to a device, further including a calibration circuit connected to the receiver, the calibration circuit including: a group of NMOS transistors connected in series, wherein respective gates of the group of NMOS transistors are connected to respective data lines received from the chip layer; and an operational amplifier connected to the group of NMOS transistors, an output of the operational amplifier connected to a calibration logic circuit configured to output data values associated with the respective data lines.

In some aspects, the techniques described herein relate to a base layer of a stacked memory module including: a physical layer that receives a through silicon via connecting a receiver of the base layer to a transmitter of a chip layer positioned over the base layer; a first inverter of the receiver including a first NMOS transistor, a first PMOS transistor, and a first stack of PMOS transistors connected to a source terminal of the first PMOS transistor; and a second inverter of the receiver including a second NMOS transistor and a second PMOS transistor, an input of the second inverter connected to an output of the first inverter.

In some aspects, the techniques described herein relate to a base layer, wherein: an input of the first inverter includes a common gate of the first NMOS transistor and the first PMOS transistor, the input of the first inverter connecting to a first voltage source; and and a terminating source terminal of the stack of PMOS transistors connects to a second voltage source that differs from the first voltage source. In some aspects, the techniques described herein relate to a base layer, wherein a source of the second PMOS transistor connects to the second voltage source.

In some aspects, the techniques described herein relate to a base layer, wherein: the input of the second inverter includes a common gate of the second NMOS transistor and the second PMOS transistor; and the output of the first inverter includes a common drain of the first NMOS transistor and the first PMOS transistor. In some aspects, the techniques described herein relate to a base layer, wherein the second inverter includes a second stack of PMOS transistors connected to a source terminal of the second PMOS transistor.

In some aspects, the techniques described herein relate to a base layer, wherein a first pull-down strength of the first NMOS transistor differs from a second pull-down strength of the second NMOS transistor. In some aspects, the techniques described herein relate to a method including: connecting, based on a through silicon via, a receiver of a base layer to a transmitter of a chip layer positioned over the base layer; receiving, at a first inverter of the receiver, a data signal from the chip layer, the first inverter including a first NMOS transistor, a first PMOS transistor, and a first stack of PMOS transistors connected to a source terminal of the first PMOS transistor; and receiving, at a second inverter of the receiver, a processed data signal from the first inverter, the second inverter including a second NMOS transistor and a second PMOS transistor, an input of the second inverter connected to an output of the first inverter.

In some aspects, the techniques described herein relate to a method, wherein: an input of the first inverter includes a common gate of the first NMOS transistor and the first PMOS transistor, the input of the first inverter connecting to a first voltage source; and and a terminating source terminal of the stack of PMOS transistors connects to a second voltage source that differs from the first voltage source. In some aspects, the techniques described herein relate to a method, wherein a source of the second PMOS transistor connects to the second voltage source.

In some aspects, the techniques described herein relate to a method, wherein: the input of the second inverter includes a common gate of the second NMOS transistor and the second PMOS transistor; and the output of the first inverter includes a common drain of the first NMOS transistor and the first PMOS transistor.

A computer-readable medium is disclosed. The computer-readable medium can store instructions that, when executed by a computer, cause the computer to perform substantially the same or similar operations as described herein are further disclosed. Similarly, non-transitory computer-readable media, devices, and systems for performing substantially the same or similar operations as described herein are further disclosed.

The memory device single-ended level shifters with duty cycle correction described herein include multiple advantages and benefits. For example, memory device single-ended level shifters provide a relatively simple design of an inverter with p-channel metal-oxide-semiconductor (PMOS) stacking that works as a level shifter with stable duty cycle. The systems and methods described may provide a chip die NN-type transmitter that reduces transmitter power consumption. Also, the systems and methods described herein avoid the clock calibration (e.g., tDQ2CLK calibration) that other systems perform. For example, the systems and methods described herein provide the benefits of low transmitter power without performing DQ clock calibration. The systems and methods described may result in no VDDQL in the base die (e.g., no VDDQL required in the base die), which results in improved power delivery network (PDN) for VDDQ and VDDH. The systems and methods described provide one-time pull-down strength calibration that improves duty cycle error, which provides a robust process, voltage, temperature (PVT) variation. Also, the worst-case inter-symbol interference (ISI) for uncalibrated systems is at or relatively near 47ps (e.g., for all corner cases) with an eye width at or relatively near 453 picoseconds (e.g., for 2 Gbps signal). Moreover, based on calibration systems described herein, the worst-case eye width is 463 picoseconds (e.g., for 2 Gbps signal), or 10 picoseconds larger than uncalibrated systems.

### BRIEF DESCRIPTION OF THE DRAWINGS

The above-mentioned aspects and other aspects of the present systems and methods will be better understood when the present application is read in view of the following figures in which like numbers indicate similar or identical elements. Further, the drawings provided herein are for purpose of illustrating certain embodiments only; other embodiments, which may not be explicitly illustrated, are not excluded from the scope of this disclosure.

These and other features and advantages of the present disclosure will be appreciated and understood with reference to the specification, claims, and appended drawings, wherein:
FIG. 1 illustrates an example system in accordance with one or more implementations as described herein.
FIG. 2 illustrates an example system in accordance with one or more implementations as described herein.
FIG. 3 illustrates an example system in accordance with one or more implementations as described herein.
FIG. 4 illustrates an example system in accordance with one or more implementations as described herein.
FIG. 5 illustrates an example system in accordance with one or more implementations as described herein.
FIG. 6 depicts a flow diagram illustrating an example method associated with the disclosed systems, in accordance with example implementations described herein.
FIG. 7 depicts a flow diagram illustrating an example method associated with the disclosed systems, in accordance with example implementations described herein.

While the present systems and methods are susceptible to various modifications and alternative forms, specific embodiments thereof are shown by way of example in the drawings and will herein be described. The drawings may not be to scale. It should be understood, however, that the drawings and detailed description thereto are not intended to limit the present systems and methods to the particular form disclosed, but to the contrary, the intention is to cover all modifications, equivalents, and alternatives falling within the spirit and scope of the present systems and methods as defined by the appended claims.

### DETAILED DESCRIPTION OF VARIOUS EMBODIMENTS

The details of one or more embodiments of the subject matter described herein are set forth in the accompanying drawings and the description below. Other features, aspects, and advantages of the subject matter will become apparent from the description, the drawings, and the claims.

Various embodiments of the present disclosure are described with reference to the accompanying drawings, in which some, but not all embodiments are shown. Indeed, the disclosure may be embodied in many forms and should not be construed as limited to the embodiments set forth herein; rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Like numbers refer to like elements throughout. Arrows in each of the figures depict bi-directional data flow and/or bi-directional data flow capabilities. The terms "path," "pathway" and "route" are used interchangeably herein.

Embodiments of the present disclosure may be implemented in various ways, including as computer program products that comprise articles of manufacture. A computer program product may include a non-transitory computer-readable storage medium storing applications, programs, program components, scripts, source code, program code, object code, byte code, compiled code, interpreted code, machine code, executable instructions, and/or the like (also referred to herein as executable instructions, instructions for execution, computer program products, program code, and/or similar terms used herein interchangeably). Such non-transitory computer-readable storage media includes all computer-readable media (including volatile and non-volatile media).

In one embodiment, a non-volatile computer-readable storage medium may include a floppy disk, flexible disk, hard disk, solid-state storage (SSS) (for example a solid-state drive (SSD)), solid state card (SSC), solid state module (SSM), enterprise flash drive, magnetic tape, or any other non-transitory magnetic medium, and/or the like. A non-volatile computer-readable storage medium may include a punch card, paper tape, optical mark sheet (or any other physical medium with patterns of holes or other optically recognizable indicia), compact disc read only memory (CD-ROM), compact disc-rewritable (CD-RW), digital versatile disc (DVD), Blu-ray disc (BD), any other non-transitory optical medium, and/or the like. Such a non-volatile computer-readable storage medium may include read-only memory (ROM), programmable read-only memory (PROM), erasable programmable read-only memory (EPROM), electrically erasable programmable read-only memory (EEPROM), flash memory (for example Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may include conductive-bridging random-access memory (CBRAM), phase-change random-access memory (PRAM), ferroelectric random-access memory (FeRAM), non-volatile random-access memory (NVRAM), magnetoresistive random-access memory (MRAM), resistive random-access memory (RRAM), Silicon-Oxide-Nitride-Oxide-Silicon memory (SONOS), floating junction gate random-access memory (FJG RAM), Millipede memory, racetrack memory, and/or the like.

In one embodiment, a volatile computer-readable storage medium may include random-access memory (RAM), dynamic random-access memory (DRAM), static random-access memory (SRAM), fast page mode dynamic random-access memory (FPM DRAM), extended data-out dynamic random-access memory (EDO DRAM), synchronous dynamic random-access memory (SDRAM), double data rate synchronous dynamic random-access memory (DDR SDRAM), double data rate type two synchronous dynamic random-access memory (DDR2 SDRAM), double data rate type three synchronous dynamic random-access memory (DDR3 SDRAM), Rambus dynamic random-access memory (RDRAM), Twin Transistor RAM (TTRAM), Thyristor RAM (T-RAM), Zero-capacitor (Z-RAM), Rambus in-line memory component (RIMM), dual in-line memory component (DIMM), single in-line memory component (SIMM), video random-access memory (VRAM), cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As should be appreciated, various embodiments of the present disclosure may be implemented as methods, apparatus, systems, computing devices, computing entities, and/or the like. As such, embodiments of the present disclosure may take the form of an apparatus, system, computing device, computing entity, and/or the like executing instructions stored on a computer-readable storage medium to perform certain steps or operations. Thus, embodiments of the present disclosure may take the form of a hardware embodiment, a computer program product embodiment, and/or an embodiment that comprises a combination of computer program products and hardware performing certain steps or operations.

Embodiments of the present disclosure are described below with reference to block diagrams and flowchart illustrations. Thus, it should be understood that each block of the block diagrams and flowchart illustrations may be implemented in the form of a computer program product, a hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially, such that one instruction is retrieved, loaded, and executed at a time. In some examples, retrieval, loading, and/or execution may be performed in parallel, such that multiple instructions are retrieved, loaded, and/or executed together. Thus, such embodiments can produce specifically configured machines performing the steps or operations specified in the block diagrams and flowchart illustrations. Accordingly, the block diagrams and flowchart illustrations support various combinations of embodiments for performing the specified instructions, operations, or steps.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not be necessarily all referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms, and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms, and a plural term may include the corresponding singular form. It is further noted that various figures (including component diagrams) shown and discussed herein are for illustrative purpose only, and are not drawn to scale. Similarly, various waveforms and timing diagrams are shown for illustrative purpose only. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some embodiments and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly referenced parts/modules are the only way to implement some of the embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on chip (SoC), an assembly, and so forth.

The provided description is presented to enable one of ordinary skill in the art to make and use the subject matter disclosed herein and to incorporate it in the context of particular applications. While the following is directed to specific examples, other and further examples may be devised without departing from the basic scope thereof.

Various modifications, as well as a variety of uses in different applications, will be readily apparent to those skilled in the art, and the general principles defined herein may be applied to a wide range of embodiments. Thus, the subject matter disclosed herein is not intended to be limited to the embodiments presented, but is to be accorded the widest scope consistent with the principles and novel features disclosed herein.

In the description provided, numerous specific details are set forth in order to provide a more thorough understanding of the subject matter disclosed herein. It will, however, be apparent to one skilled in the art that the subject matter disclosed herein may be practiced without necessarily being limited to these specific details. In other instances, well-known structures and devices are shown in block diagram form, rather than in detail, in order to avoid obscuring the subject matter disclosed herein.

All the features disclosed in this specification (e.g., any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described herein with reference to the figures. It should be noted that the figures are only intended to facilitate the description of the features. The various features described are not intended as an exhaustive description of the subject matter disclosed herein or as a limitation on the scope of the subject matter disclosed herein. Additionally, an illustrated example need not have all the aspects or advantages shown. An aspect or an advantage described in conjunction with a particular example is not necessarily limited to that example and can be practiced in any other examples even if not so illustrated, or if not so explicitly described.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the claims herein is not intended to invoke the provisions of 35 U.S.C. 112, Paragraph 6.

It is noted that, if used, the labels left, right, front, back, top, bottom, forward, reverse, clockwise and counterclockwise have been used for convenience purposes only and are not intended to imply any particular fixed direction. Instead, the labels are used to reflect relative locations and/or directions between various portions of an object.

Data processing may include data buffering, aligning incoming data from multiple communication lanes, forward error correction (FEC), etc. For example, data may be received by an analog front end (AFE), which can prepare the incoming data for digital processing. The digital portion of the transceivers (e.g., digital signal processor (DSP)) may provide skew management, equalization, reflection cancellation, and/or other functions. It is to be appreciated that the process described herein can provide many benefits, including saving both power and cost.

Moreover, the terms "system," "component," "module," "interface," "model," or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution, and a component may be localized on one computer and/or distributed between two or more computers.

Unless explicitly stated otherwise, each numerical value and range may be interpreted as being approximate, as if the word "about" or "approximately" preceded the value of the value or range. Signals and corresponding nodes or ports might be referred to by the same name and are interchangeable for purposes here.

While embodiments may have been described with respect to circuit functions, the embodiments of the subject matter disclosed herein are not limited. Possible implementations may be embodied in a single integrated circuit, a multi-chip module, a single card, SoC, or a multi-card circuit pack. As would be apparent to one skilled in the art, the various embodiments might also be implemented as part of a larger system. Such embodiments may be employed in conjunction with, for example, a digital signal processor, microcontroller, field-programmable gate array, application-specific integrated circuit, or general-purpose computer.

As would be apparent to one skilled in the art, various functions of circuit elements may also be implemented as processing blocks in a software program. Such software may be employed in, for example, a digital signal processor, microcontroller, or general-purpose computer. Such software may be embodied in the form of program code embodied in tangible media, such as magnetic recording media, optical recording media, solid-state memory, floppy diskettes, CD-ROMs, hard drives, or any other non-transitory machine-readable storage medium, that when the program code is loaded into and executed by a machine, such as a computer, the machine becomes an apparatus for practicing the subject matter disclosed herein. When implemented on a general-purpose processor, the program code segments combine with the processor to provide a unique device that operates analogously to specific logic circuits. Described embodiments may also be manifest in the form of a bit stream or other sequence of signal values electrically or optically transmitted through a medium, stored magnetic-field variations in a magnetic recording medium, etc., generated using a method and/or an apparatus as described herein.

Some memory systems may include one or more chip layers stacked on top of a base layer. The system may include a transmitter circuit on a chip layer and a receiver circuit on a base layer. Communication between layers may be based on through-silicon vias (TSVs). TSVs can include vertical electrical connections that pass through a silicon wafer or die. The transmitter circuit may connect to the receiver circuit through a TSV. For example, data read from a memory cell on the chip layer may be communicated by the transmitter to the receiver through the TSV. In some cases, the transmitter and/or the receiver may include an inverter. For example, the transmitter and/or receiver may include a complementary metal oxide semiconductor (CMOS) inverter based on a p-channel metal-oxide-semiconductor (PMOS) transistor and n-channel metal-oxide-semiconductor (NMOS) transistor. In some cases, the transmitter and the receiver may be connected to VDDQ (e.g., voltage supply of data lines or DQ pins). With the transmitter, the source terminal of the PMOS may connect to VDDQ and the source terminal of the NMOS may connect to ground. Thus, the transmitter may connect the TSV to VDDQ for a logical 1 or to ground for a logical 0. Because the transmitter and receiver are connected to VDDQ, there are no duty cycle issues (e.g., balanced on time, off time in data signal). However, connecting the transmitter and the receiver to VDDQ result in a relatively large transmit power consumption.

Some memory systems may implement an NMOS-NMOS (NN-type) transmitter connected to a voltage lower than VDDQ (e.g., low VDDQ, VDDQL), adding an inverter to the gate of the NMOS transistor that replaces the PMOS transistor. Again, the transmitter may connect to the receiver through a TSV. Accordingly, the transmitter may connect the TSV to VDDQL or to ground. The receiver may receive a signal from the transmitter based on VDDQL, and may output a signal based on VDDQ. While other voltages may be used, in some examples, VDDQ may be 0.7 volts (V) and VDDQL may be 0.4 V. In some cases, the receiver may include a sampler that receives the output of the transmitter, is connected to a reference voltage, and synchronized with a data clock (e.g., data to clock calibration, tDQ2CLK calibration). In some cases, the sampler may sample the data signal from the TSV on an edge of the clock (e.g., on rising edge of the clock). Based on the transmitter connected to VDDQL, the transmit power consumption is reduced. However, this system requires generation of a reference voltage to sample the input data signal. Additionally, this system requires calibration of the data clock based on data path to clock mismatches, which results in additional overhead to implement this system.

Some systems may include an NN-type transmitter connected to VDDQL (e.g., with an inverter on the NMOS connected to the voltage source) and a PN-type receiver connected to VDDQ. Another PN-type inverter, also connected to VDDQ, may receive the output from the receiver. This configuration provides relatively low transmitter power consumption and does not require data clock calibration, but it can result in a duty cycle error in the signal output by the receiver and the inverter connected to the receiver (e.g., mismatch between on time and off time of the data signal).

The systems and methods described herein may incorporate and/or may be based on an NN-type transmitter connected to VDDQL and a PN-type receiver connected to VDDQ, the transmitter providing a data signal to the receiver through a TSV connected between the receiver the transmitter. In some cases, the receiver may include a level-shifting inverter. For example, the first inverter may include a PN-type inverter connected to a stack of PMOS transistors that delay pull up in the data signal, providing a low-power transmitter with little to no duty-cycle error. The systems and methods provide a relatively simple receiver in a memory device that is implemented in a relatively small area.

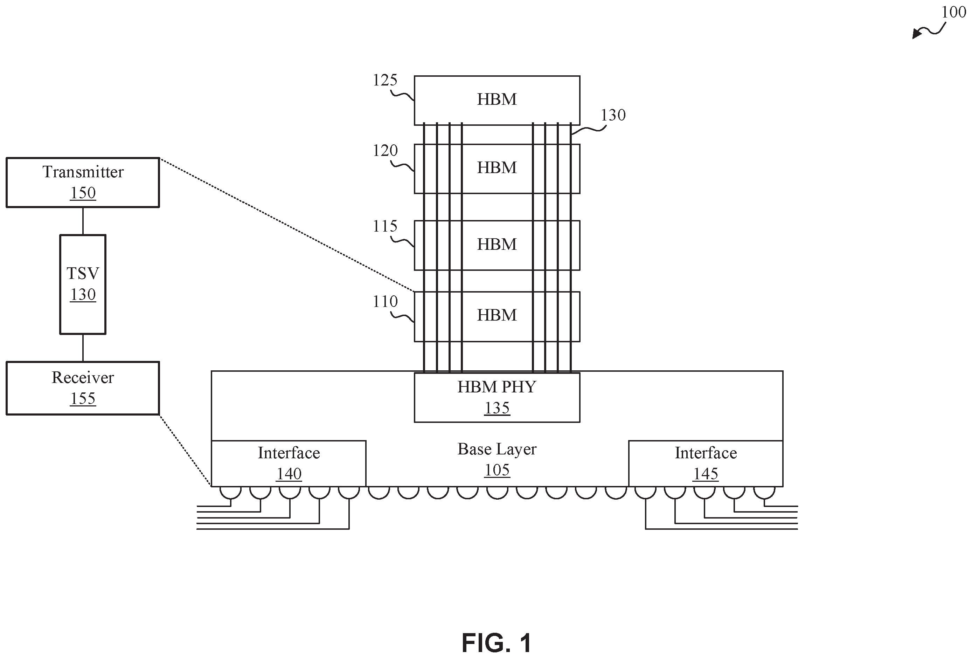

**FIG. 1** illustrates an example system 100 in accordance with one or more implementations as described herein. In some configurations, one or more aspects of system 100 may be implemented by or in conjunction with a memory device. For example, one or more aspects of system 100 may be implemented by or in conjunction with a stacked memory device (e.g., HBM, VSDRAM).

System 100 may include or may be based on high-bandwidth memory (HBM). HBM can include a type of dynamic random-access memory (DRAM) that stacks multiple memory dies vertically, using through-silicon vias (TSVs) to achieve a wider data bus than planar DRAM memory, leading to superior speed, power efficiency, and a smaller physical footprint. HBM architectures enable significantly higher bandwidth, making HBM ideal for demanding applications such as artificial intelligence (AI), high-performance computing, graphics processing, etc. Also, system 100 may include or may be based on one or more physical interfaces for die-to-die communication (e.g., interface for physical and protocol layers), which may include a physical layer (PHY) interface and/or a universal chiplet interconnect express (UCle) interface. UCle may include a die-to-die interconnect for connecting one or more base dies (e.g., within a single package).

In the illustrated example, system 100 may include base layer 105, one or more chip layers (e.g., HBM 110, HBM 115, HBM 120, HBM 125), TSVs 130, and one or more die-to-die interconnects (e.g., interface 140, interface 145). As shown, base layer 105 may include a physical interface (e.g., HBM PHY 135) connected to TSVs 130. Although the chip layers are depicted as HBM, any type of stacked memory may be used.

As shown, base layer 105 may include a ball grid array, which may connect base layer 105 to a substrate layer. In some cases, system 100 may include one or more chip layers (e.g., 4 chip layers in the depicted example). In some cases, a chip layer may be accessed individually. For example, the depicted chip layers may be associated with a 4-bit data bus, which may include four parallel data lines, D3, D2, D1, and D0, that transfer data in and out of the chip layers. In some examples, D3 may be the most significant bit (MSB), D2 the second most significant bit, D1 the third most significant bit, and D0 the least significant bit (LSB). In some cases, a d<3:0> data bus may connect these four bits of data across the chip layers. In some cases, HBM 110 may be associated with D0 (e.g., d<0>), HBM 115 may be associated with D0 (e.g., d<1>), HBM 120 may be associated with D0 (e.g., d<2>), HBM 125 may be associated with D0 (e.g., d<3>). However, any possible combination may be used to assign a data line from the data bus to a given chip layer.

A given TSV may connect transmit (TX) / receive (RX) channels for a number of memory dies (e.g., 4 memory dies) and a base die of base layer 105. In some cases, a chip layer (e.g., HBM 110) may include one or more transmitters (e.g., transmitter 150) and base layer 105 (e.g., HBM PHY 135) may include one or more receivers (e.g., receiver 155). As shown, a given TSV of TSVs 130 may connect transmitter 150 to receiver 155. In some cases, base layer 105 may be referred to as a base die and chip layers may be referred to chip dies.

Memory devices may include a number of data TSVs (e.g., HBM3 has 1024 DQ TSVs; HBM4 has 2048 DQ TSVs). The number of data TSVs is continually increasing, which increases power consumption. The systems and methods described herein may provide mechanisms to enable system 100 to reduce power consumption associated with data transmissions (e.g., reduce power consumption of transmitter 150, HBM PHY 135, etc.).

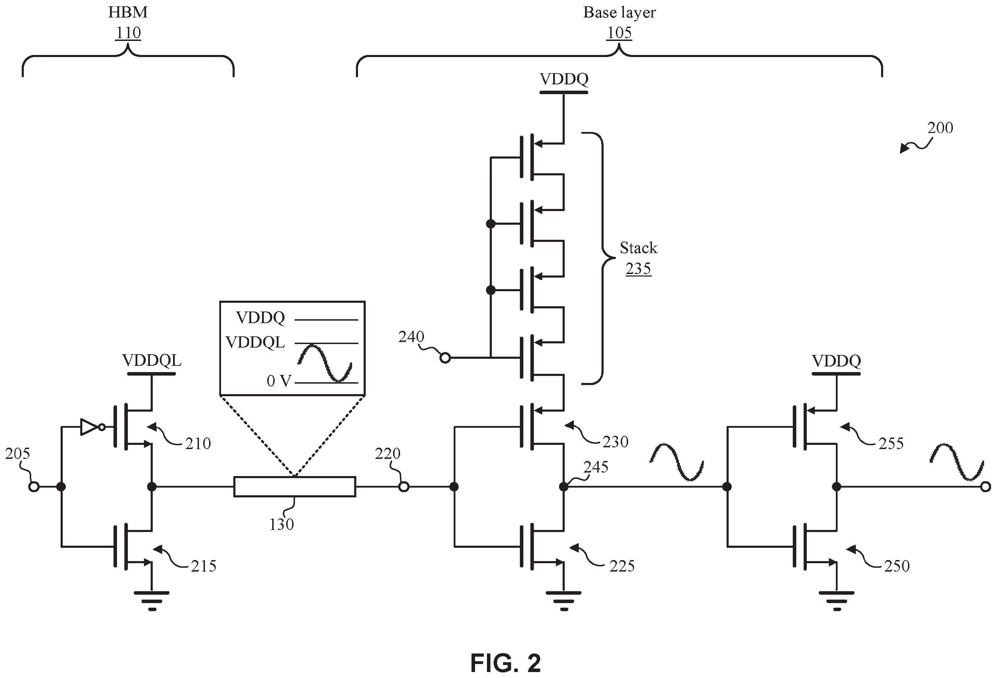

**FIG. 2** illustrates an example system 200 in accordance with one or more implementations as described herein. In some configurations, one or more aspects of system 200 may be implemented by or in conjunction with a memory device (e.g., of system 100). In some configurations, one or more aspects of system 200 may be implemented by or in conjunction with a stacked memory device (e.g., HBM, VSDRAM).

In the illustrated example, system 200 may depict components of a chip die (e.g., HBM 110) and a base die (e.g., base layer 105). As shown, HBM 110 may include transmitter circuitry, which may include node 205, transistor 210 (e.g., NMOS transistor), and transistor 215 (e.g., NMOS transistor). In some cases, node 205 connects to a data line. For example, node 205 may receive data values read from memory cells of HBM 110. As shown, transistor 210 may include an inverter at its gate terminal, thus, node 205 may connect to the gate of transistor 215 and connect to the inverter of transistor 210. A drain terminal of transistor 210 may connect to VDDQL (e.g., 0.4 V) and the source of transistor 210 may connect to TSV 130. Similarly, the drain of transistor 215 may connect to TSV 130 and a source terminal of transistor 215 may connect to ground. In some cases, transistor 210 and transistor 215 may be configured as an NN-type transmitter that provides data signals to TSV 130.

In the illustrated example, base layer 105 may include receiver circuitry, which may include node 220, transistor 225, transistor 230, a stack of transistors (e.g., stack 235), node 240, node 245, transistor 250, and transistor 255. In some cases, the components of the depicted receiver circuitry may provide level-shifting (e.g., level-shifting inverter). A level shifter may be based on an electronic circuit that converts signals between different voltage levels, ensuring compatibility between components that operate at different supply voltages. Level shifters can act as a bridge, translating logic levels from one voltage domain to another (e.g., between microcontrollers, sensors, peripherals, etc. with varying voltages). In some cases, the level-shifting of the receiver circuitry may provide a shift from VDDQL to VDDQ.

In some cases, transistor 225 and transistor 230 may be configured as a first inverter of the receiver circuitry. Transistor 250 and transistor 255 may be configured as a second inverter of the receiver circuitry. As shown, transistor 225 may be an NMOS transistor and transistor 230 may be a PMOS transistor. Thus, the first inverter of the receiver may include a PN-type inverter (e.g., of transistor 225 and transistor 230) with common gate terminals connecting to node 220. As shown, node 220 connects to TSV 130, which may provide a data signal based on VDDQL (e.g., 0.4 V).

In the illustrated example, the first inverter of transistor 225 and transistor 230 may connect to a stack of PMOS transistors (e.g., stack 235). As shown, a common drain of the first inverter of transistor 225 and transistor 230 may connect to node 245 (e.g., output of the first inverter). A source terminal of transistor 225 may connect to ground, while a source terminal of transistor 230 may connect to stack 235. A common gate terminal of the transistors of stack 235 may connect to node 240. Node 240 may connect to tie-low (tielo). For example, node 240 may connect to a tie cell rather than a direct power connection (e.g., direct connection to ground) to protect the transistor gate oxide from damage caused by voltage fluctuations. As shown, a drain of a first transistor of stack 235 may connect to a source of transistor 230. Also, a source of the first transistor of stack 235 may connect to a drain of a second transistor of stack 235, and so on, until a terminating or top transistor of stack 235. As shown, the terminating transistor of stack 235 may connect to VDDQ (e.g., 0.7 V).

The configuration of the PMOS transistors in stack 235 may match one or more characteristics of the PMOS transistor in the first inverter (e.g., characteristics of transistor 230). For example, transistor 230 and the PMOS transistors in stack 235 may be rated with at least one of the same doping levels, same base width, same current gain, same breakdown voltage, same saturation voltage, same input/output impedance, same switching speed, and/or the same power handling capability.

In some cases, stack 235 may be configured to provide a pull-up delay on the data signal received at node 220. Since pull up gets weaker based on stack 235, the duty cycle on the output of the first inverter at 245 provides a more balanced response (e.g., at or near 50/50 duty cycle). In some cases, a second inverter (e.g., PN-type) may be connected to the first inverter. The second inverter may include transistor 250 and transistor 255. As shown, transistor 250 may be an NMOS transistor and transistor 255 may be a PMOS transistor. A common gate of transistor 250 and transistor 255 may connect to node 245 (e.g., output of the first inverter). A source terminal of transistor 250 may connect to ground and a source terminal of transistor 255 may connect to VDDQ. A common drain of the second inverter of transistor 250 and transistor 255 may provide an output of the receiver circuitry. This output may provide a 50% duty cycle (e.g., at or relatively near 50% duty cycle) with relatively low transmission power consumption (e.g., based on VDDQL).

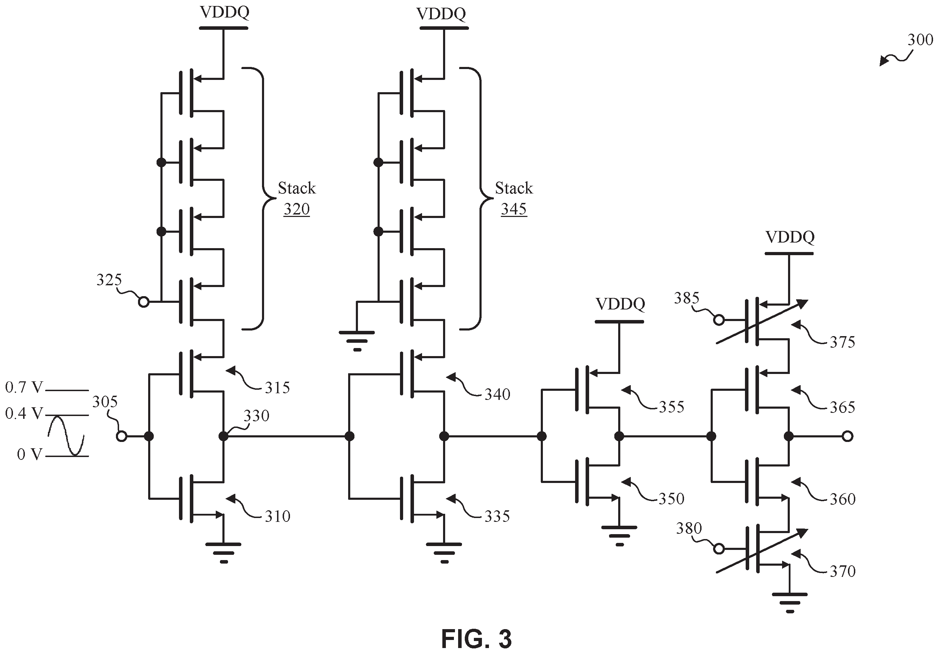

**FIG. 3** illustrates an example system 300 in accordance with one or more implementations as described herein. In some configurations, one or more aspects of system 300 may be implemented by or in conjunction with a memory device (e.g., of system 100). In some configurations, one or more aspects of system 300 may be implemented by or in conjunction with a stacked memory device (e.g., HBM, VSDRAM). In some cases, system 300 may be implemented in a receiver (e.g., receiver 155) connected to a TSV (e.g., TSV 130), where the TSV is connected to a transmitter (e.g., transmitter 150).

In the illustrated example, system 300 may depict receiver circuitry, which may include node 305, transistor 310, transistor 315, a stack of transistors (e.g., stack 320), node 325, and node 330. In some cases, system 300 may be implemented in a base layer (e.g., base layer 105), where node 305 connects to a TSV (e.g., TSV 130) and the TSV connects to a transmitter of a chip layer (e.g., HBM 110) that provides a data signal to system 300 (e.g., at VDDQL, such as 0.4 V). In some cases, the receiver circuitry may include a first inverter based on transistor 310 and transistor 315, where transistor 315 connects to stack 320. As shown, transistor 310 may be an NMOS transistor and transistor 315 may be a PMOS transistor. In some cases, stack 320 may be based on and/or configured similarly to stack 235 of FIG. 2. For example, transistors of stack 320 may have one or more characteristics similar to transistor 315. The source of transistor 310 may connect to ground and the source of transistor 315 may connect to stack 320. Similar to stack 235, the terminating transistor of stack 320 may connect to VDDQ. Node 325 may connect to common gates of transistors of stack 320. Node 325 may receive a data read signal. In some cases, node 325 may receive a data signal based on the data read from memory or an inverted feed of the data read from memory.

In the illustrated example, the receiver circuitry of system 300 may include transistor 335, transistor 340, and stack 345. In some cases, the receiver circuitry may include a second inverter based on transistor 335 and transistor 340, where transistor 340 connects to stack 345. In some cases, transistor 335 may be an NMOS transistor and transistor 340 may be a PMOS transistor. As shown, transistor 335 may be an NMOS transistor and transistor 340 may be a PMOS transistor. In some cases, stack 345 may be based on and/or configured similarly to stack 235 of FIG. 2. For example, PMOS transistors of stack 345 may have one or more characteristics similar to transistor 340. As shown, node 330 (e.g., output of the first inverter) may connect to the common gates of transistor 335 and transistor 340. The source of transistor 335 may connect to ground and the source of transistor 340 may connect to stack 345. Similar to stack 235, the terminating transistor of stack 345 may connect to VDDQ.

In the illustrated example, the receiver circuitry of system 300 may include transistor 350, transistor 355. In some cases, the receiver circuitry may include a third inverter based on transistor 350 and transistor 355. In some cases, transistor 350 may be an NMOS transistor and transistor 355 may be a PMOS transistor. The source of transistor 350 may connect to ground and the source of transistor 355 may connect to VDDQ (e.g., 0.7 V). As shown, the common drains of transistor 335 and transistor 340 (e.g., output of the second inverter) may connect to common gates of transistor 350 and transistor 355 (e.g., input of the third inverter).

In the illustrated example, the receiver circuitry of system 300 may include transistor 360, transistor 365. In some cases, the receiver circuitry may include a fourth inverter based on transistor 360, transistor 365, transistor 370, and transistor 375. In some cases, transistor 360 and transistor 370 may be NMOS transistors. Transistor 365 and transistor 375 may be PMOS transistors. As shown, the common drains of transistor 350 and transistor 355 (e.g., output of the third inverter) may connect to common gates of transistor 360 and transistor 365 (e.g., input of the fourth inverter). The source of transistor 360 may connect to the drain of transistor 370 and the source of transistor 365 may connect to the drain of transistor 375. The source of transistor 370 may connect to ground and the source of transistor 375 may connect to VDDQ (e.g., 0.7 V). As shown, common drains of transistor 360 and transistor 365 may provide an output of the receiver circuitry (e.g., output of the fourth inverter).

In some cases, transistor 370 and transistor 375 may be variable. For example, may be configured as variable resistors. The gate terminal of transistor 370 may connect to node 380, and the gate terminal of transistor 375 may connect to node 385. Node 380 and node 385 may receive respective data synchronization signals. The data synchronization signals may be associated with the data lines of respective HBM layers (e.g., d<3:0>). In some cases, the data synchronization signals may be based on differential pairs of signals, or complementary signals. For example, node 380 may receive negative data synchronization signals (e.g., d_nstr<3:0>) and node 385 may receive positive data synchronization signals (e.g., d_pstr<3:0>, or vice versa.

In some cases, the transistors of stack 320 may match one or more characteristics of the transistors of stack 345. Accordingly, stack 320 and stack 345 may be configured to match a pull-up timing on the data signal (e.g., based on both stacks being connected to VDDQ). In some cases, transistor 310 and transistor 335 may be configured to match a pull-down timing on the data signal. In some cases, the pull-down strength of transistor 310 (e.g., 400 mV) may be less than the pull-down strength of transistor 335 (e.g., 700 mV). In some cases, the NMOS size of transistor 310 may be greater than the NMOS size of transistor 335. Based on this configuration, transistor 310 and transistor 335 may match a pull-down timing on the data signal.

Because of variations in process voltage and/or temperature (PVT) of individual components of system 300, duty cycle equalization is unlikely to be perfectly 50% based on some residual duty cycle error. In some cases, transistor 370 and transistor 375 may provide duty cycle correction to correct the residual duty cycle error (e.g., 1% to 5% residual duty cycle error), getting the output data signal closer to 50% duty cycle.

The depicted configuration of system 300 provides a 50% duty cycle (e.g., at or relatively near 50% duty cycle, relatively small duty cycle error) with relatively low transmission power consumption (e.g., based on VDDQL). Also, the depicted configuration of system 300 operates without data clock calibration, avoiding the related overhead of data clock calibration. Also, based on the configuration of system 300, the worst-case inter-symbol interference (ISI) is at or relatively near 47ps (e.g., for all corner cases). Testing of the configuration of system 300 shows an eye width at or relatively near 453 picoseconds (e.g., for 2 Gbps signal).

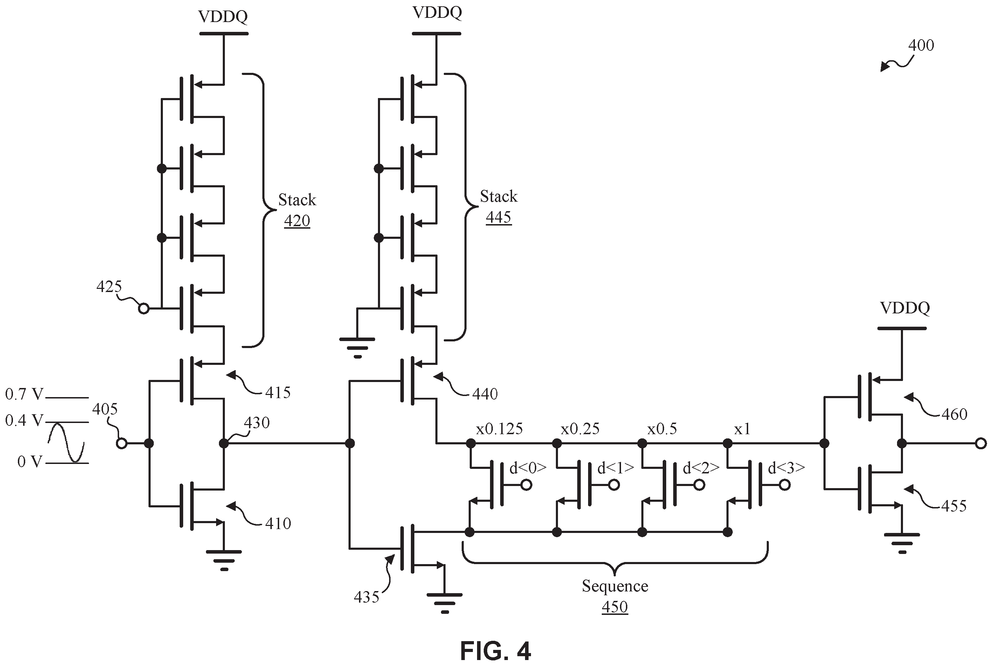

**FIG. 4** illustrates an example system 400 in accordance with one or more implementations as described herein. In some configurations, one or more aspects of system 400 may be implemented by or in conjunction with a memory device (e.g., of system 100). In some configurations, one or more aspects of system 400 may be implemented by or in conjunction with a stacked memory device (e.g., HBM, VSDRAM). In some cases, system 400 may be implemented in a receiver (e.g., receiver 155) connected to a TSV (e.g., TSV 130), where the TSV is connected to a transmitter (e.g., transmitter 150).

In the illustrated example, system 400 may depict receiver circuitry, which may include node 405, transistor 410, transistor 415, a stack of transistors (e.g., stack 420), node 425, and node 430. In some cases, system 400 may be implemented in a base layer (e.g., base layer 105), where node 405 connects to a TSV (e.g., TSV 130) and the TSV connects to a transmitter of a chip layer (e.g., HBM 110) that provides a data signal to system 400 (e.g., at VDDQL, such as 0.4 V). In some cases, the receiver circuitry may include a first inverter based on transistor 410 and transistor 415, where transistor 415 connects to stack 420. As shown, transistor 410 may be an NMOS transistor and transistor 415 may be a PMOS transistor. In some cases, stack 420 may be based on and/or configured similarly to stack 235 of FIG. 2. For example, transistors of stack 420 may have one or more characteristics similar to transistor 415. The source of transistor 410 may connect to ground and the source of transistor 415 may connect to stack 420. Similar to stack 235, the terminating transistor of stack 420 may connect to VDDQ. Node 425 may connect to common gates of transistors of stack 420. Node 425 may connect to a data read signal. In some cases, node 425 may receive data read from memory or an inverted feed of the data read from memory.

In the illustrated example, the receiver circuitry of system 400 may include transistor 435, transistor 440, and stack 445. In some cases, the receiver circuitry may include a second inverter based on transistor 435 and transistor 440, where transistor 440 connects to stack 445. In some cases, transistor 435 may be an NMOS transistor and transistor 440 may be a PMOS transistor. As shown, transistor 435 may be an NMOS transistor and transistor 440 may be a PMOS transistor. In some cases, stack 445 may be based on and/or configured similarly to stack 235 of FIG. 2. For example, PMOS transistors of stack 445 may have one or more characteristics similar to transistor 440. As shown, node 430 (e.g., output of the first inverter) may connect to the common gates of transistor 435 and transistor 440. The source of transistor 435 may connect to ground and the source of transistor 440 may connect to stack 445. Similar to stack 235, the terminating transistor of stack 445 may connect to VDDQ. The characteristics of the transistors of stack 445 may match the characteristics of the transistors of stack 420 (e.g., providing equivalent pull-up strength).

In the illustrated example, the receiver circuitry of system 400 may include a group of transistors connected in parallel (e.g., sequence 450, sequence of NMOS transistors in parallel). In some cases, sequence 450 may be configured as a programmable resistor. As shown, the drain of transistor 435 may connect to a first rail of sequence 450 (e.g., common source rail of the transistors of sequence 450). The drain of transistor 440 may connect to a second rail of sequence 450 (e.g., common drain rail of the transistors of sequence 450). As shown, the gate of a first transistor of sequence 450 receives a first data signal (e.g., d<0>), the gate of a second transistor of sequence 450 receives a second data signal (e.g., d<1>), the gate of a third transistor of sequence 450 receives a third data signal (e.g., d<2>), and the gate of a fourth transistor of sequence 450 receives a fourth data signal (e.g., d<3>). Also, the drain of the first transistor provides a signal at a first relative strength (e.g., 0.125), the drain of the second transistor provides a signal at a second relative strength (e.g., 0.25), the drain of the third transistor provides a signal at a third relative strength (e.g., 0.5), the drain of the fourth transistor provides a signal at a fourth relative strength (e.g., 1.0).

In the illustrated example, the common drains of the transistors of sequence 450 connect to common gates of transistor 455 and transistor 460. The source terminal of transistor 455 is connected to ground and the source terminal of transistor 460 is connected to VDDQ (e.g., 0.7 V). Common drains of transistor 455 and transistor 460 may provide an output of system 400. The depicted configuration of system 400 provides a 50% duty cycle (e.g., at or relatively near 50% duty cycle, relatively small duty cycle error) with relatively low transmission power consumption (e.g., based on VDDQL). Also, the depicted configuration of system 400 operates without data clock calibration, avoiding the related overhead of data clock calibration.

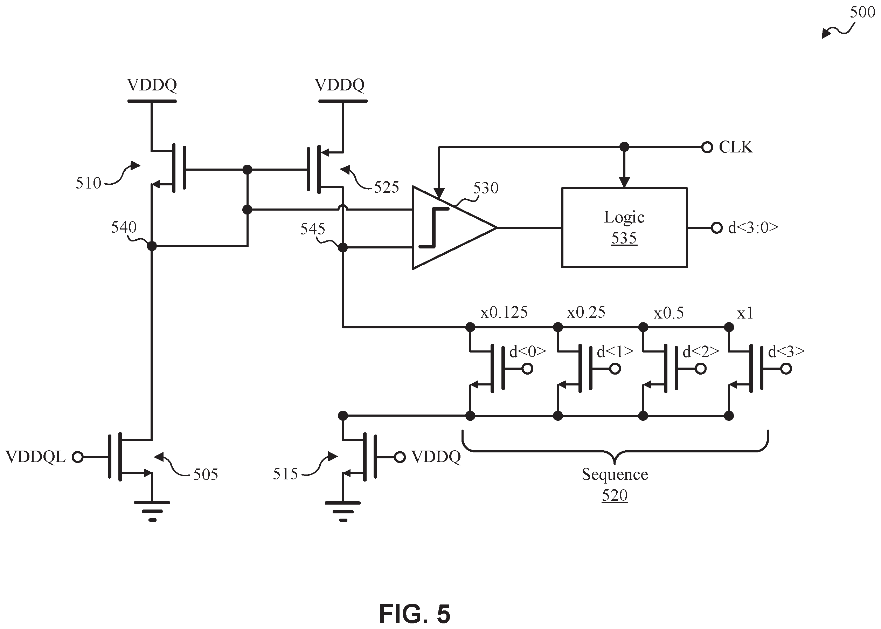

**FIG. 5** illustrates an example system 500 in accordance with one or more implementations as described herein. In some configurations, one or more aspects of system 500 may be implemented by or in conjunction with a memory device (e.g., of system 100). In some configurations, one or more aspects of system 500 may be implemented by or in conjunction with a stacked memory device (e.g., HBM, VSDRAM). In some cases, system 500 may be implemented in a receiver (e.g., receiver 155) connected to a TSV (e.g., TSV 130), where the TSV is connected to a transmitter (e.g., transmitter 150).

In the illustrated example, system 500 may depict calibration circuitry, which may include transistor 505 (e.g., NMOS transistor), transistor 510 (e.g., NMOS transistor), transistor 515 (e.g., NMOS transistor), a group of transistors connected in parallel (e.g., sequence 520, sequence of NMOS transistors in parallel), transistor 525 (e.g., PMOS transistor), operational amplifier (op-amp) 530, and logic 535.

As shown, a gate terminal of transistor 505 may connect to VDDQL (e.g., 0.4 V), a source of transistor 505 may connect to ground, and a drain of transistor 505 may connect to node 540, where node 540 connect to a source terminal of transistor 510, common gates of transistor 510 and of transistor 525, and a first input of op-amp 530. Also, a drain of transistor 510, a gate of transistor 515, and a source of transistor 525 connect, respectively, to VDDQ (e.g., 0.7 V). A source of transistor 515 connects to ground and a drain of transistor 515 connects to a first rail of sequence 520 (e.g., common source rail of the transistors of sequence 520). As shown, a drain of transistor 525 connects to node 545, which connects to a second input of op-amp 530 and a second rail of sequence 520 (e.g., common drain rail of the transistors of sequence 520). A clock signal connects to op-amp 530 and logic 535. An output of op-amp connects to logic 535, and an output of logic 535 provides a data signal (e.g., d<3:0>).

In some cases, sequence 520 may be configured as a programmable resistor. As shown, the gate of a first transistor of sequence 520 receives a first data signal (e.g., d<0>), the gate of a second transistor of sequence 520 receives a second data signal (e.g., d<1>), the gate of a third transistor of sequence 520 receives a third data signal (e.g., d<2>), and the gate of a fourth transistor of sequence 520 receives a fourth data signal (e.g., d<3>). Also, the drain of the first transistor provides a signal at a first relative strength (e.g., 0.125), the drain of the second transistor provides a signal at a second relative strength (e.g., 0.25), the drain of the third transistor provides a signal at a third relative strength (e.g., 0.5), the drain of the fourth transistor provides a signal at a fourth relative strength (e.g., 1.0). In some cases, at least one characteristic of the transistors of sequence 520 matches at least one corresponding characteristic of the transistors of sequence 450.

System 500 may be implemented in a memory device. For example, the calibration circuitry of system 500 may be configured to calibrate a receiver of a memory device. A given memory device (e.g., system 100) may include thousands of TSVs. Accordingly, it may not be practical to put the calibration circuitry of system 500 on every RX circuit (e.g., receiver circuitry of system 200, system 300, and/or system 400). Accordingly, the calibration circuitry of system 500 may be implemented for a subset of RX circuits of a given memory device (e.g., every 5 RX circuits, every 10 RX circuits, every 32 RX circuits, or 64 RXs RX circuits, every 128 RX circuits, etc.).

In some cases, transistor 505 may match at least one characteristic of transistor 410 and transistor 515 may match at least one characteristic of transistor 435. In some cases, transistor 505 may be identical characteristic-wise to transistor 410, and transistor 515 may be identical characteristic-wise to transistor 435. Based on this matching transistor characteristics, the calibration circuitry of system 500 may be configured to measure the pull-down strength of a first transistor (e.g., transistor 310, transistor 410) with VDDQL (e.g., 0.4 V) applied, and measure the pull-down strength of a second transistor (e.g., transistor 335, transistor 435) with VDDQ (e.g., 0.7 V) applied. The transistors of sequence 520 may be configured as a programmable resistor (e.g., variable R). The transistors of sequence 520 may be programmed to equalize a first pull-down time of a first transistor (e.g., transistor 310, transistor 410) and a second pull-down time of a second transistor (e.g., transistor 335, transistor 435). As shown, the calibration circuitry of system 500 has a first NMOS transistor 505 connected to VDDQL (e.g., similar to transistor 310, transistor 410, etc.), and a second NMOS transistor 515 connected to VDDQ (e.g., similar to transistor 335, transistor 435).

In some cases, the calibration circuitry of system 500 may be configured to compare (e.g., in conjunction with logic 535) two outputs (e.g., node 540 and node 545). In the illustrated example, comparator 530 may be a clocked comparator (e.g., based on CLK). As shown, comparator 530 may compare node 540 to node 545. In some cases, comparator 530 may perform the comparison on a rising edge of CLK. Alternatively, comparator 530 may perform the comparison on a falling edge of CLK. As shown, the result of this comparison may be provided to logic 535. In some cases, logic 535 may update d<3:0> until the polarity of the comparator output flips.

Transistor 510 and transistor 525 may be considered current sources of system 500 based on VDDQ. The same current may flow to node 540 and node 545, and the respective voltages of node 540 and node 545 may be measured. If it is determined, based on the comparison, that the voltage of 540 is less than node 545 (e.g., node 540 produces less voltage than node 545 when the same current is applied), then this indicates that transistor 505 is stronger (e.g., transistor 505 has less resistance) relative to transistor 515.

To compensate for transistor 505 being stronger than transistor 515, the programmable resistance of sequence 520 may be decreased to decrease the path of resistance of transistor 515 to ground. Thus, the pull-down resistance of transistor 515 is configured to match the pull-down resistance of transistor 505. As a result, the pull-down timing of transistor 505 matches the pull-down timing of transistor 515, providing a duty cycle at or relatively near 50%.

In some cases, the programmable resistance of sequence 520 may be applied to the programmable resistance of sequence 450. As a result, the pull-down resistance of transistor 410 matches the pull-down resistance of transistor 435. As a result, the pull-down timing of transistor 410 matches the pull-down timing of transistor 435, providing a duty cycle at or relatively near 50%.

The systems and methods described herein may be based on a single-ended level shifter with PMOS stacking. The techniques described herein include logic to provide single-ended level shifters with duty cycle correction. The logic includes any combination of logical circuitry and/or hardware (e.g., at least one memory, at least one processor) to provide single-ended level shifters with duty cycle correction.

The systems and methods described herein may improve eye width based on testing results, where Y-axis showed eye width and X-axis showed control code. Four worst corners were tested (sf, -40, VDDQ=0.8 V, VDDQL=0.34, 0.46V), (fs, -40, VDDQ=0.62 V, VDDQL=0.34, 0.46V). For the different corners, different data signals d<3:0> were set to make two outputs similar. The worst-case eye width measured was 463 picoseconds (e.g., for 2 Gbps signal), or 10 picoseconds larger than uncalibrated systems.

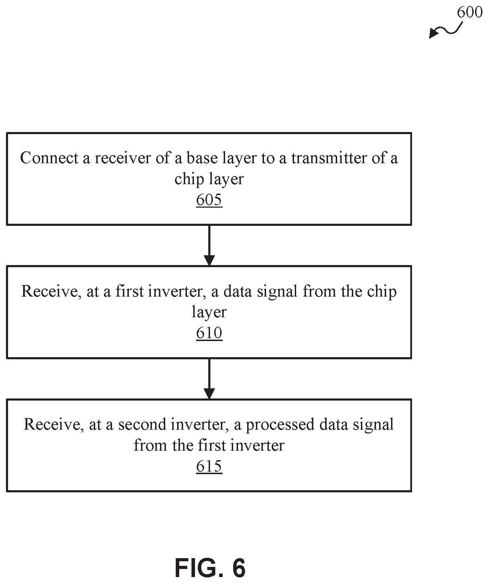

**FIG. 6** depicts a flow diagram illustrating an example method 600 associated with the disclosed systems, in accordance with example implementations described herein. The depicted method 600 is just one implementation and one or more operations of method 600 may be rearranged, reordered, omitted, and/or otherwise modified such that other implementations are possible and contemplated.

At 605, method 600 may include connecting a receiver of a base layer to a transmitter of a chip layer. For example, method 600 may include connecting, based on a through silicon via, a receiver of a base layer to a transmitter of a chip layer, multiple chip layers, including the chip layer, being positioned over the base layer.

At 610, method 600 may include receiving, at a first inverter, a data signal from the chip layer. For example, method 600 may include receiving, at a first inverter of the receiver, a data signal from the chip layer, the first inverter comprising a first NMOS transistor, a first PMOS transistor, and a first stack of PMOS transistors connected to a source terminal of the first PMOS transistor.

At 615, method 600 may include receiving, at a second inverter, a processed data signal from the first inverter. For example, method 600 may include receiving, at a second inverter of the receiver, a processed data signal from the first inverter, the second inverter comprising a second NMOS transistor and a second PMOS transistor.

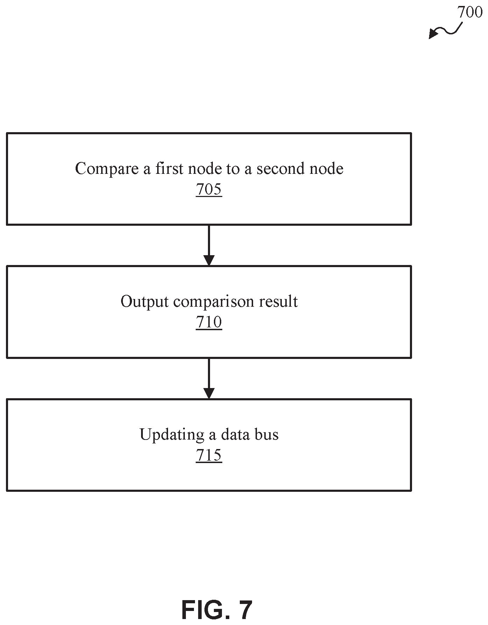

**FIG. 7** depicts a flow diagram illustrating an example method 700 associated with the disclosed systems, in accordance with example implementations described herein. The depicted method 700 is just one implementation and one or more operations of method 700 may be rearranged, reordered, omitted, and/or otherwise modified such that other implementations are possible and contemplated.

At 705, method 700 may include comparing a first node to a second node. For example, method 700 may include a comparator comparing a voltage of a first node to a voltage of a second node (e.g., comparator 530 comparing node 540 to node 545).

At 710, method 700 may include outputting a comparison result. For example, method 700 may include a result of comparing the voltage of the first node to the voltage of the second node to a logic device (e.g., comparator 530 outputting comparison result to logic 535).

At 715, method 700 may include updating a data bus. For example, method 700 may include updating a data bus until a polarity of the comparator output flips (e.g., logic 535 updates d<3:0> until a polarity of the output of comparator 530 flips). For instance, logic 535 may be configured to detect when the polarity of the output of comparator 530 flips and to stop updating d<3:0> upon detecting the polarity of the output of comparator 530 flipping.

In the examples described herein, the configurations and operations are example configurations and operations, and may involve various additional configurations and operations not explicitly illustrated. In some examples, one or more aspects of the illustrated configurations and/or operations may be omitted. In some embodiments, one or more of the operations may be performed by components other than those illustrated herein. Additionally, or alternatively, the sequential and/or temporal order of the operations may be varied.

Certain embodiments may be implemented in one or a combination of hardware, firmware, and software. Other embodiments may be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media.

The word "exemplary" is used herein to mean "serving as an example, instance, or illustration." Any embodiment described herein as "exemplary" is not necessarily to be construed as preferred or advantageous over other embodiments. The terms "computing device," "user device," "communication station," "station," "handheld device," "mobile device," "wireless device" and "user equipment" (UE) as used herein refers to a wired and/or wireless communication device such as a switch, router, network interface controller, cellular telephone, smartphone, tablet, netbook, wireless terminal, laptop computer, a femtocell, High Data Rate (HDR) subscriber station, access point, printer, point of sale device, access terminal, or other personal communication system (PCS) device. The device may be wireless, wired, mobile, and/or stationary.

As used within this document, the term "communicate" is intended to include transmitting, or receiving, or both transmitting and receiving. Similarly, the bidirectional exchange of data between two devices (both devices transmit and receive during the exchange) may be described as 'communicating', when only the functionality of one of those devices is being claimed. The term "communicating" as used herein with respect to wired and/or wireless communication signals includes transmitting the wired and/or wireless communication signals and/or receiving the wired and/or wireless communication signals. For example, a communication unit, which is capable of communicating wired and/or wireless communication signals, may include a wired/wireless transmitter to transmit communication signals to at least one other communication unit, and/or a wired/wireless communication receiver to receive the communication signal from at least one other communication unit.

Some embodiments may be used in conjunction with various devices and systems, for example, a Personal Computer (PC), a desktop computer, a mobile computer, a laptop computer, a notebook computer, a tablet computer, a server computer, a handheld computer, a handheld device, a Personal Digital Assistant (PDA) device, a handheld PDA device, an on-board device, an off-board device, a hybrid device, a vehicular device, a non-vehicular device, a mobile or portable device, a consumer device, a non-mobile or non-portable device, a wireless communication station, a wireless communication device, a wireless Access Point (AP), a wired or wireless router, a wired or wireless modem, a video device, an audio device, an audio-video (A/V) device, a wired or wireless network, a wireless area network, a Wireless Video Area Network (WVAN), a Local Area Network (LAN), a Wireless LAN (WLAN), a Personal Area Network (PAN), a Wireless PAN (WPAN), and the like.

Some embodiments may be used in conjunction with one way and/or two-way radio communication systems, cellular radio-telephone communication systems, a mobile phone, a cellular telephone, a wireless telephone, a Personal Communication Systems (PCS) device, a PDA device which incorporates a wireless communication device, a mobile or portable Global Positioning System (GPS) device, a device which incorporates a GPS receiver or transceiver or chip, a device which incorporates an RFID element or chip, a Multiple Input Multiple Output (MIMO) transceiver or device, a Single Input Multiple Output (SIMO) transceiver or device, a Multiple Input Single Output (MISO) transceiver or device, a device having one or more internal antennas and/or external antennas, Digital Video Broadcast (DVB) devices or systems, multi-standard radio devices or systems, a wired or wireless handheld device, e.g., a Smartphone, a Wireless Application Protocol (WAP) device, or the like.

Some embodiments may be used in conjunction with one or more types of wireless communication signals and/or systems following one or more wireless communication protocols, for example, Radio Frequency (RF), Infrared (IR), Frequency-Division Multiplexing (FDM), Orthogonal FDM (OFDM), Time-Division Multiplexing (TDM), Time-Division Multiple Access (TDMA), Extended TDMA (E-TDMA), General Packet Radio Service (GPRS), extended GPRS, Code-Division Multiple Access (CDMA), Wideband CDMA (WCDMA), CDMA 2000, single-carrier CDMA, multi-carrier CDMA, Multi-Carrier Modulation (MDM), Discrete Multi-Tone (DMT), Bluetooth^{™}, Global Positioning System (GPS), Wi-Fi, Wi-Max, ZigBee^{™}, Ultra-Wideband (UWB), Global System for Mobile communication (GSM), 2G, 2.5G, 3G, 3.5G, 4G, Fifth Generation (5G) mobile networks, 3GPP, Long Term Evolution (LTE), LTE advanced, Enhanced Data rates for GSM Evolution (EDGE), or the like. Other embodiments may be used in various other devices, systems, and/or networks.

Although an example processing system has been described above, embodiments of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more components of computer program instructions, encoded on computer storage medium for execution by, or to control the operation of, information/data processing apparatus. Alternatively, or in addition, the program instructions can be encoded on an artificially-generated propagated signal, for example, a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (for example multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, for example, an FPGA or an ASIC. The apparatus can also include, in addition to hardware, code that creates an execution environment for the computer program in question, for example code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a component, component, subroutine, object, or other unit suitable for use in a computing environment. A computer program may, but need not, correspond to a file in a file system. A program can be stored in a portion of a file that holds other programs or information/data (for example one or more scripts stored in a markup language document), in a single file dedicated to the program in question, or in multiple coordinated files (for example files that store one or more components, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random-access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, for example magnetic, magneto-optical disks, or optical disks. However, a computer need not have such devices. Devices suitable for storing computer program instructions and information/data include all forms of non-volatile memory, media and memory devices, including by way of example semiconductor memory devices, for example EPROM, EEPROM, and flash memory devices; magnetic disks, for example internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, for example, a CRT (cathode ray tube) or LCD (liquid crystal display) monitor, for displaying information/data to the user and a keyboard and a pointing device, for example, a mouse or a trackball, by which the user can provide input to the computer. Other kinds of devices can be used to provide for interaction with a user as well; for example, feedback provided to the user can be any form of sensory feedback, for example visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, for example, as an information/data server, or that includes a middleware component, for example, an application server, or that includes a front-end component, for example, a client computer having a graphical user interface or a web browser through which a user can interact with an embodiment of the subject matter described herein, or any combination of one or more such back-end, middleware, or front-end components. The components of the system can be interconnected by any form or medium of digital information/data communication, for example, a communication network. Examples of communication networks include a local area network ("LAN") and a wide area network ("WAN"), an inter-network (for example the Internet), and peer-to-peer networks (for example ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (for example, an HTML page) to a client device (for example, for purposes of displaying information/data to and receiving user input from a user interacting with the client device). Information/data generated at the client device (for example, a result of the user interaction) can be received from the client device at the server.

While this specification contains many specific embodiment details, these should not be construed as limitations on the scope of any embodiment or of what may be claimed, but rather as descriptions of features specific to particular embodiments. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain embodiments, multitasking and parallel processing may be advantageous.

Many modifications and other examples as set forth herein will come to mind to one skilled in the art to which these embodiments pertain to having the benefit of the teachings presented in the foregoing descriptions and the associated drawings. Therefore, it is to be understood that the embodiments are not to be limited to the specific embodiments disclosed and that modifications and other embodiments are intended to be included within the scope of the appended claims. Although specific terms are employed herein, they are used in a generic and descriptive sense only and not for purposes of limitation. A number of example implementations have been described. Nevertheless, it will be understood that various modifications may be made without departing from the spirit and scope of the disclosure. Accordingly, additional implementations are within the scope of the following claims.

## Claims

1. A base layer of a stacked memory module comprising:
a physical layer that receives a through silicon via connecting a receiver of the base layer to a transmitter of a first chip layer positioned over the base layer;
a first inverter of the receiver comprising a first NMOS transistor, a first PMOS transistor, and a first stack of PMOS transistors connected to a source terminal of the first PMOS transistor; and
a second inverter of the receiver comprising a second NMOS transistor and a second PMOS transistor, an input of the second inverter connected to an output of the first inverter.

2. The base layer of claim 1, wherein:
an input of the first inverter comprises a common gate of the first NMOS transistor and the first PMOS transistor, the input of the first inverter connecting to a first voltage source; and
and a terminating source terminal of the stack of PMOS transistors connects to a second voltage source that differs from the first voltage source.

3. The base layer of claim 2, wherein a source of the second PMOS transistor connects to the second voltage source.

4. The base layer of any one of claims 1 to 3, wherein:
the input of the second inverter comprises a common gate of the second NMOS transistor and the second PMOS transistor; and
the output of the first inverter comprises a common drain of the first NMOS transistor and the first PMOS transistor.

5. The base layer of any one of claims 1 to 4, wherein the second inverter comprises a second stack of PMOS transistors connected to a source terminal of the second PMOS transistor.

6. The base layer of any one of claims 1 to 5, wherein:
a third inverter of the receiver connected to the second inverter, the third inverter comprising a third NMOS transistor and a third PMOS transistor; and
a fourth inverter of the receiver connected to the third inverter, the fourth inverter comprising a fourth NMOS transistor and a fourth PMOS transistor.

7. The base layer of claim 6, wherein:
a source of the fourth PMOS transistor is connected to a fifth PMOS transistor configured as a first variable resistor; and
a source of the fourth NMOS transistor is connected to a fifth NMOS transistor configured as a second variable resistor.

8. The base layer of any one of claims 1 to 7, further comprising a group of NMOS transistors connected in series between a drain terminal of the second PMOS transistor and a drain terminal of the second NMOS transistor.

9. A device comprising:
the base layer according to any one of claims 1 to 8;
multiple chip layers positioned over the base layer, the multiple chip layers including the first chip layer;
the through silicon via that connects the receiver of the base layer to the transmitter of the first chip layer.

10. The device of claim 9, further comprising a calibration circuit connected to the receiver, the calibration circuit comprising:
a group of NMOS transistors connected in series, wherein respective gates of the group of NMOS transistors are connected to respective data lines received from the chip layer; and
an operational amplifier connected to the group of NMOS transistors, an output of the operational amplifier connected to a calibration logic circuit configured to output data values associated with the respective data lines.

11. The device of claim 9 or 10, wherein the device is a stacked memory module.
